# EUROPEAN PATENT SPECIFICATION

(11) **EP 3 646 490 B1**
(45) Date of publication and mention of the grant of the patent: **04.11.2026**
(21) Application number: 18733607.8
(22) Date of filing: 25.06.2018
(51) Int. Cl.: G01R 31/28, H04B 17/21, H04B 17/345, G01R 29/08

(54) **SYSTEM FOR CHARACTERIZING A WIRELESS COMMUNICATION COMPONENT AND METHOD FOR CHARACTERIZING A WIRELESS COMMUNICATION COMPONENT USING A DETERMINATION OF PERTURBATION**
SYSTEM ZUR CHARAKTERISIERUNG EINES DRAHTLOSKOMMUNIKATIONSBESTANDTEILS VERFAHREN ZUR CHARAKTERISIERUNG EINES DRAHTLOSKOMMUNIKATIONSBESTANDTEILS MIT EINER STÖRUNGSBESTIMMUNG
SYSTÈME ET PROCÉDÉ DE COMMUNICATIONS SANS FIL EMPLOYÉS POUR CARACTÉRISER UN COMPOSANT DE COMMUNICATION VIA LA DÉTERMINATION D'UNE PERTURBATION

(30) Priority: 26.06.2017 EP 17177932
(43) Date of publication of application: 06.05.2020
(73) Proprietor: Fraunhofer-Gesellschaft zur Förderung der angewandten Forschung e.V., 80686 München (DE)
(72) Inventor: ASKAR, Ramez, 14193 Berlin (DE); LEATHER, Paul Simon Holt, 14169 Berlin (DE); SAKAGUCHI, Kei, 10115 Berlin (DE); HAUSTEIN, Thomas, 14469 Potsdam (DE); KEUSGEN, Wilhelm, 14089 Berlin (DE)
(74) Representative: Burger, Markus
(86) International application number: PCT/EP2018/066989
(87) International publication number: WO 2019/002221

(56) References cited:
- WO-A1-03/056349
- WO-A1-2016/178778
- FRECH A ET AL: "Time-domain EMI measurements in the presence of ambient noise", ELECTROMAGNETIC COMPATIBILITY, 2009. EMC 2009. IEEE INTERNATIONAL SYMPOSIUM ON, IEEE, PISCATAWAY, NJ, USA, 17 August 2009 (2009-08-17), pages 139 - 142, XP031544934, ISBN: 978-1-4244-4266-9

## Description

Embodiments of the present invention generally relate to characterization of wireless communication components and/or systems and/or networks. Embodiments according to the invention are related to a system that observes and corrects environmental changes in a characterization of such devices.

### Background of the Invention

Performing over-the-air (OTA) measurements in non-anechoic environments will lead to a major reduction in building costs, as the need for the construction of an anechoic chamber becomes unnecessary. This will ease the entire OTA measurement procedure and make it possible for such measurements to be performed almost anywhere, irrespective of the surrounding environment.

Currently, OTA measurements take place in specially constructed surroundings such as multi-probe anechoic chambers (MPAC) or reverberation chambers [1]. This is to create controlled multipath environments.

Presently, three main types of OTA measurement environments are proposed for standardization; the multi-probe anechoic chamber (MPAC), the compact antenna test range (CATR), and the reverberation chamber (RC) [1]. In a typical OTA measurement setup, the device under test (DUT), probes and the environment in which they reside, are arranged in such a way that the effects of multi-path reflection are eliminated or, at least reduced to a required level. This is in order to ensure measurement repeatability. All state-of-the-art solutions have thus considered OTA measurement setups that take place in controlled environments.

WO/2003/056349 A1 describes an antenna measurement range and a method of calibrating same. The method of calibrating the range comprises the steps of: generating and radiating a training signal; receiving the radiated training signal and comparing the received signal with the expected signal; determining a set of equaliser coefficients to be used in these circumstances to eliminate or minimise the error between the expected training signal and the received signal; and storing the set of equalisation coefficients and associating them with the rotational or translational position of the antenna under test so that the coefficients can be applied to subsequent radiation pattern measurements.

WO/2016/178778 A1 describes a system that obtains performance measurements, identifies a performance measurement from the performance measurements that is below performance threshold and, in turn, initiates corrective action to improve the performance measurement of an affected network element falling below the performance threshold. The performance measurements can be determined from measurements associated with signals generated by communication devices, noise levels in a spectral portion used by communication devices to transmit the signals, and interference signals exceeding an adaptive inter-cell interference threshold.

Frech, A. et al.: Time-Domain EMI Measurements in the Presence of Ambient Noise", in: Electromagnetic Compatibility, 2009. IEEE International Symposium, Piscataway, NJ, USA August 17, 2009, pages 139-142, describe adaptive cancelation techniques to suppress ambient noise in electromagnetic interference measurements on open area test sites.

Therefore, a desire exists for an improved concept which enables a better, e.g. more flexible or reliable, characterization of wireless communication components and/or systems and/or networks.

### Summary of the Invention

Embodiments according to the invention are defined by the independent claims.

Further embodiments disclosed herein which do not comprise all features defined in a respective independent claim, or equivalents thereof, are examples that are helpful for understanding the invention.

An embodiment according to the invention provides a system for characterizing a wireless communication component in a measurement environment using over-the-air measurements according to claim 1. The wireless communication component may, for example, be a mobile phone or a radio system of a mobile phone. The wireless communication system may, for example, comprise one or more base stations and one or more mobile phones. The wireless communication network may, for example, comprise one or more base stations and one or more mobile phones and one or more control servers.

The described system is based on the idea that, when performing measurements for characterization of the wireless communication system or/and component or/and network, it is beneficial to determine (or detect) if a perturbation of the measurement environment is occurring. The system may for example indicate to a further measurement equipment (or to a further component of the system) that the perturbation has been determined and an appropriate reaction can be performed by the further measurement equipment(or by the further component of the system). The further measurement equipment (or the further component of the system ) may, for example, counteract the perturbation or label the measurement as compromised, based on the determination. Thus, it is possible to perform measurements in environments which are prone to perturbations (e.g. to a change of channel characteristics or to the presence of perturbing radio sources), which brings along an improved flexibility.

Further embodiments are defined in the appended dependent claims.

Embodiments according to the invention provide for a method for use in a characterization of a wireless communication component according to claim 16.

A further preferred embodiment of the invention is a computer program according to claim 17.

### Brief Description of the Figures

In the following, embodiments of the present invention will be explained with reference to the accompanying drawings, in which:
- Fig. 1: shows a schematic block diagram of an apparatus according to embodiments of the invention;
- Fig. 2: shows a schematic block diagram of a system according to embodiments of the invention;
- Fig. 3: shows a schematic block diagram of a system according to embodiments of the invention in a downlink configuration;
- Fig. 4a: shows a schematic block diagram of a system according to embodiments of the invention in an uplink configuration;
- Fig. 4b: shows a schematic block diagram of a system according to embodiments of the invention in a combined uplink and downlink configuration;
- Fig. 5: shows a schematic of a measurement scenario in a first time step according to embodiments of the invention;
- Fig. 6: shows a schematic of a measurement scenario in a second time step according to embodiments of the invention;
- Fig. 7: shows a schematic block diagram of a wireless communication component according to embodiments of the invention;
- Fig. 8: shows a flow chart of a method according to embodiments of the invention;
- Fig. 9: shows a flow chart of a method according to embodiments of the invention.

### Detailed Description of the Embodiments

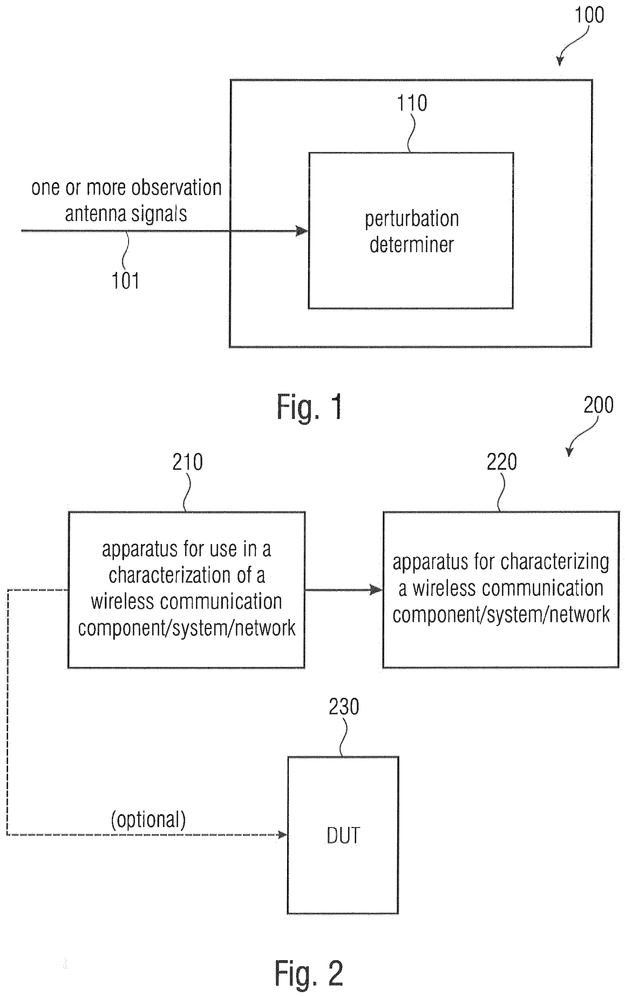

Fig. 1 shows a schematic block diagram of an apparatus 100 according to embodiments of the invention. The apparatus 100 for use in a characterization of a wireless communication component/system/network is configured to determine a perturbation of a measurement environment based on one or more observation antenna signals 101. For example, using perturbation determiner 110.

The features and functionalities of apparatus 100 will be described in more detail in context of the systems 200, 300, 400, 500 and 600 in Figs. 2-6. Moreover, apparatus 100 of Fig. 1 can be supplemented by any of the features and functionalities described herein, either individually or in combination.

Fig. 2 shows a schematic block diagram of a system 200 according to embodiments of the invention. The system 200 for characterizing a wireless communication component/system/network comprises an apparatus 210 for use in a characterization of a wireless communication component/system/network, e.g. apparatus 100, and an apparatus 220 for characterizing a wireless communication component/system/network. Further, a device under test (DUT) 230, e.g. a wireless communication component/system/network, can be characterized by the system 200. Moreover, the apparatus 210 for use in a characterization of a wireless communication component/system/network is configured to provide measurement observation information to the apparatus for characterizing a wireless communication component/system/network.

The apparatus 210 can for example detect or determine if an interfering source is active in the measurement environment and report the activity. Moreover, the apparatus 210 may be able to provide an estimate of the interference to the apparatus 220, which may be able to compensate an influence of the interference on a characterization, based on the interference estimate. Alternatively or in addition, the apparatus 210 may be able to detect a change of a geometry of the measurement environment, leading to a changed channel impulse response between measurement antennas and a device under test. Upon detection, the detection may be reported to apparatus 220 or directly used to initiate an re-estimation of a channel impulse response in the apparatus 220 or in the device under test 230.

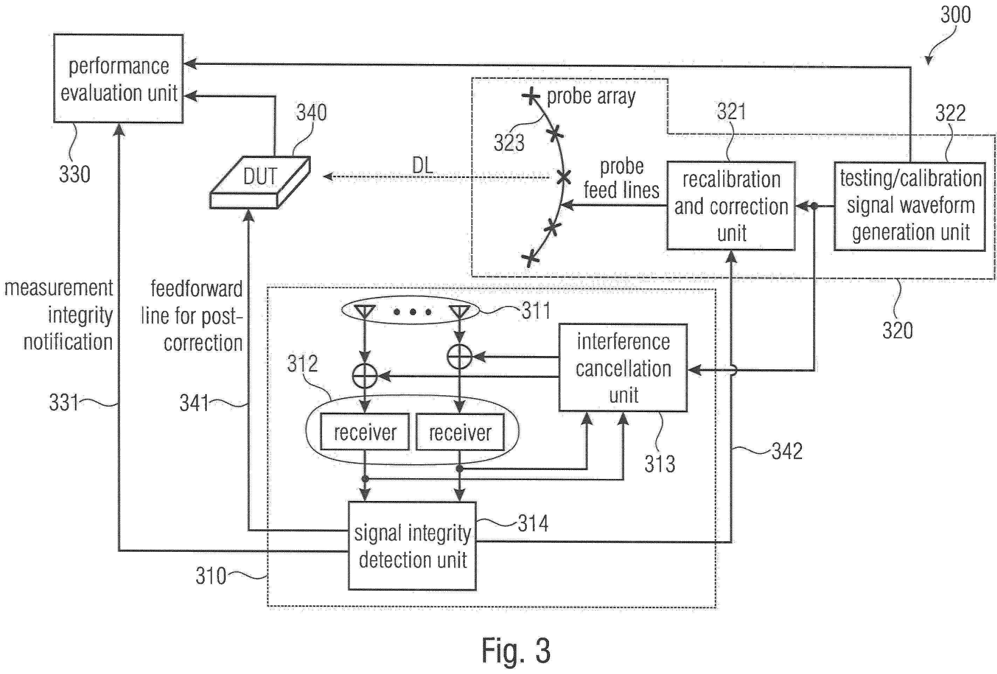

Fig. 3 shows a schematic block diagram of a system 300 according to embodiments of the invention in a downlink configuration. The system 300 comprises an apparatus 310 for use in a characterization of a wireless communication component/system/network, an apparatus for characterizing a wireless communication component/system/network 320, a performance evaluation unit 330. Furthermore, a DUT 340, e.g. a wireless communication component/system/network, is set up for characterization in a downlink configuration, i.e. signals are being transmitted from the system 300 to the DUT 340.

The apparatus 310, as a further embodiment of apparatus 100, may comprise observation antennas 311, which are each connected to individual receivers 312. Moreover, the apparatus 310 may comprise an interference cancellation unit 313, which uses test signals provided by the apparatus 320, to at least partially remove contributions of the test signals onto the observation antenna signals. For that purpose, the interference cancellation unit 313 may be calibrated initially and recalibrated upon changes of the measurement environment. Furthermore, the apparatus 320 may comprise a signal integrity detection unit 314 which is provided with the observation antenna signals, after removal of contributions of the test signals and reception by the receivers 312, to determine perturbations. The apparatus 310 may indicate a determined perturbation to the apparatus 320 and/or the performance evaluation unit 330 and/or the DUT 340. Moreover, the interference cancellation unit 313 may be adapted using the observation antenna signals after the at least partial removal/compensation of the test signals. Thereby, the interference cancellation unit 313 may obtain a channel estimate, e.g. a channel impulse response, to perform the compensation. Further, the signal integrity unit 314 may for example use a correlation to detect whether a perturbation is caused by a change of a room geometry or by an external interferer.

Moreover, the apparatus 320 may comprise a recalibration and correction unit 321, a testing/calibration signal waveform generation unit 322 and/or a probe array 323. The recalibration and correction unit 321 may use test signals provided by the testing/calibration signal waveform generation unit 322 to obtain channel estimates. The recalibration and correction unit 321 may use the channel estimates (e.g. in the form inverted channel impulse responses) to precondition the test signals before transmission to the DUT 340 via the probe array 323, such that the test signals may be received substantially free of multi-path propagation effects at the DUT 340. In addition to compensating undesired channel characteristics, a pre-distortion may optionally be applied, to thereby emulate a desired channel characteristic.

Moreover, the testing/calibration signal waveform generation unit 322 may provide the test signals (or control signals indicating which test signals should be transmitted to the DUT) to the performance evaluation unit 320 and/or the interference cancellation unit 313 and/or the recalibration and correction unit 321.

Furthermore, the performance evaluation unit 330 may be used to evaluate a characterization or to label a characterization as compromised/invalid if an undesired interferer was active, which could not be compensated for. For that purpose, the performance evaluation unit is being notified by the apparatus 310 via a measurement integrity notification line 331.

The DUT 340 may be provided with an interference estimate via a feed-forward line for post-correction 341. The interference estimate may be used by the DUT 340 to remove unwanted signal contributions from a received signal for characterization (or during characterization) of the DUT 340.

Alternatively, the performance evaluation unit 330 may be part of the apparatus 320.

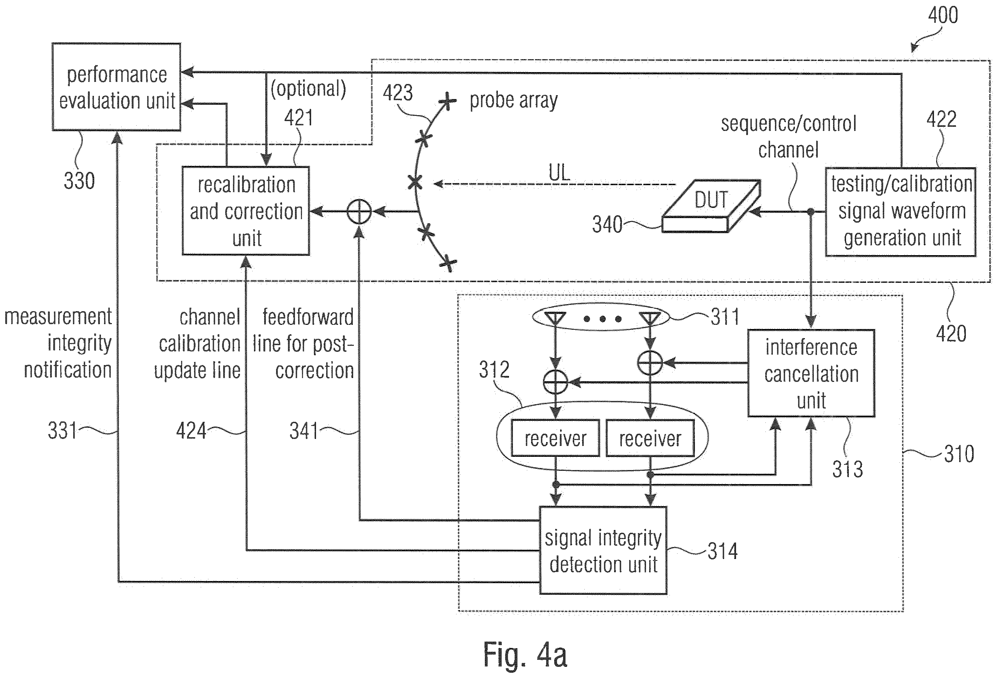

Fig.4a shows a schematic block diagram of a system 400 according to embodiments of the invention in an uplink configuration. The system 400 is similar to the system 300 and comprises the apparatus 310 and an apparatus 420 for characterization of a wireless communication component/system/network. Moreover, the system 400 may comprise the performance evaluation unit 330 and a DUT 340 may be arranged in a test environment, in which the system is located.

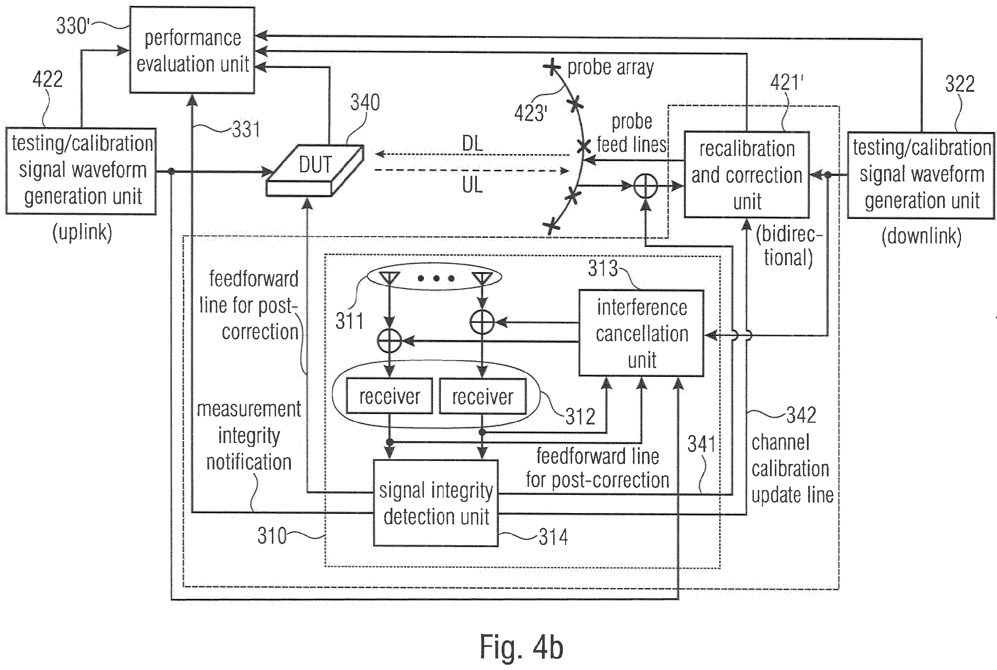

Fig. 4b show a bidirectional measurement setup in which the features and functionalities correspond to the features and functionalities describe with reference to Figs. 3 and 4a. Blocks having identical reference numerals comprise similar functionalities. The performance evaluation unit 330' combines the functionalities of the performance evaluation unit 330 according to Fig. 3 and of the performance evaluation unit 330 according to Fig. 4a. Recalibration and correction unit 421' is a bidirectional unit and combines the functionalities of the recalibration and correction units 421 and 321. The probe array 423' is a bidirectional probe array an combines the functionalities of the probe arrays 323 and 423. Thus, the arrangement of Fig. 4b allows for test of both uplink and downlink functionalities, wherein the apparatus 310 is reused in both link directions.

The apparatus 310 has the same functionalities and features as described with respect to Fig. 3.

The apparatus 420 is, in comparison to apparatus 320, slightly altered to work in uplink configuration, i.e. test signals are received from the DUT 340 by the apparatus 420. For that end, the apparatus 420 may perform an equalization of multipath propagation effects in a recalibration an correction unit 421. For that purpose, the recalibration and correction unit 421 may have initially estimated (inverted) channel impulse responses, which can be used in combination with test signals emitted by the DUT 340 to at least partially compensate an effect of multipath propagation. The compensation may alternatively also be performed at the performance evaluation unit 330. Moreover, the apparatus 420 comprises a testing/calibration signal waveform generation unit 422 which provides the test signals (or control signals indicating which test signals should be transmitted by the DUT) to the DUT 340 and/or the apparatus 310 and/or the recalibration and correction unit 421 and/or the performance evaluation unit 330. Further, the apparatus 420 may comprise a probe array 423 to receive signals from the DUT 340.

Moreover, the apparatus 420 may compensate for an external interferer using an interference estimate, for example, obtained via the feed-forward line for post-correction 341. Furthermore, the apparatus may be set to re-estimate a channel estimate upon reception of a notice via a channel calibration update line 424.

To conclude, the systems 200, 300 and 400 can observe a measurement of a DUT, such that perturbations caused, e.g. by change of a room geometry of the measurement environment or by an undesired object and/or caused by an interfering source, can be determined. Based on the determination the systems can react appropriately, e.g. use countermeasures like interference cancellation or re-estimation of channel estimates used for characterization of the DUT. Alternatively or additionally, the determination of the perturbation can be used to grade a measurement, e.g. mark it as invalid if strong perturbations occurred, e.g. indicating a need of repeating a measurement.

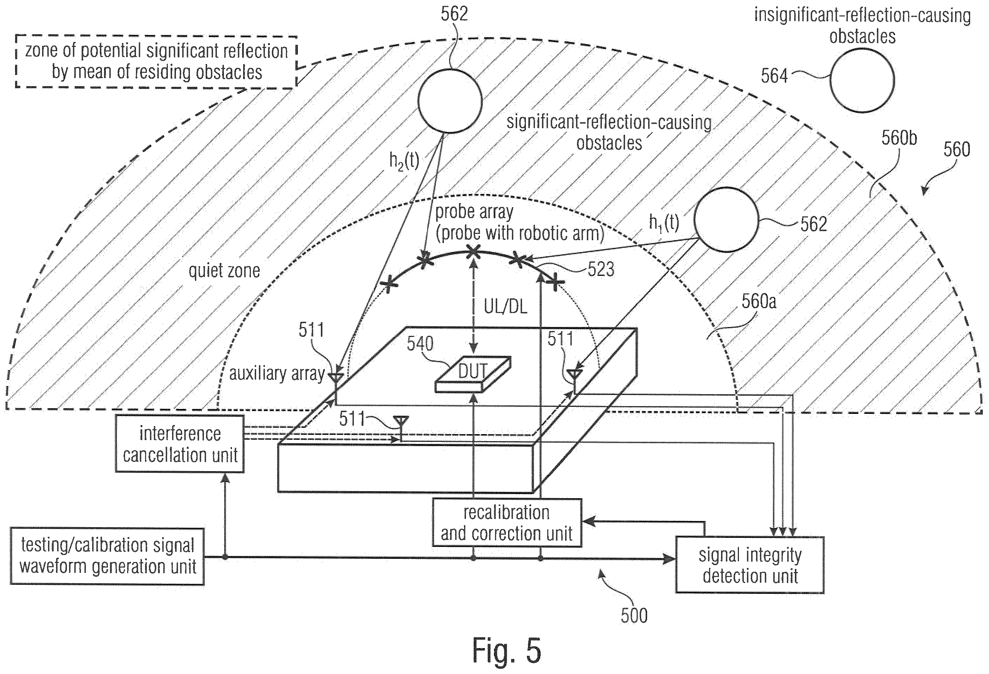

Fig. 5 shows a schematic of a measurement scenario in a first time step according to embodiments of the invention. In the measurement scenario a system 500 is used, corresponding to systems 200 or 300 or 400. The system comprises a probe array (e.g. an antenna array or an antenna movable, e.g., by a robotic arm) 523 used for characterization of a DUT 540 and an auxiliary probe array 511 used for an observation of the characterization. The auxiliary probe array 511 is used to obtain the observation antenna signals.

The auxiliary antenna array 511 comprises, for example, 3 antennas (generally speaking, at least one antenna, or typically more than two antennas such as a distributed or collocated antenna array). The probe array 523 for characterization of the DUT 540 is arranged (or movable), for example, along an arc over the DUT 540.

The DUT 540 is placed in a measurement environment 560, which comprises a quiet zone (a zone where environment changes are not supposed to occur) 560a and an outer zone 560b. In the measurement environment first obstacles 562 are present which cause reflections, which may be perceived by antennas of the system 500 or the DUT 540. Therefore, a calibration is first performed to account for the reflections of the first obstacles 562. The first obstacles 562 are, for example, arranged further distanced from the DUT 540 than the probe array 523 and are also typically further distanced from the DUT 540 than the auxiliary antennas 511. Moreover, second obstacles 564 may be present in the measurement environment, which are sufficiently distanced to the system 500 or the DUT 540, such that no significant influence is perceived, due to reflections from the second obstacles 564. In other words, the second obstacles 564 are located further away from the DUT 540 than the first obstacles 562.

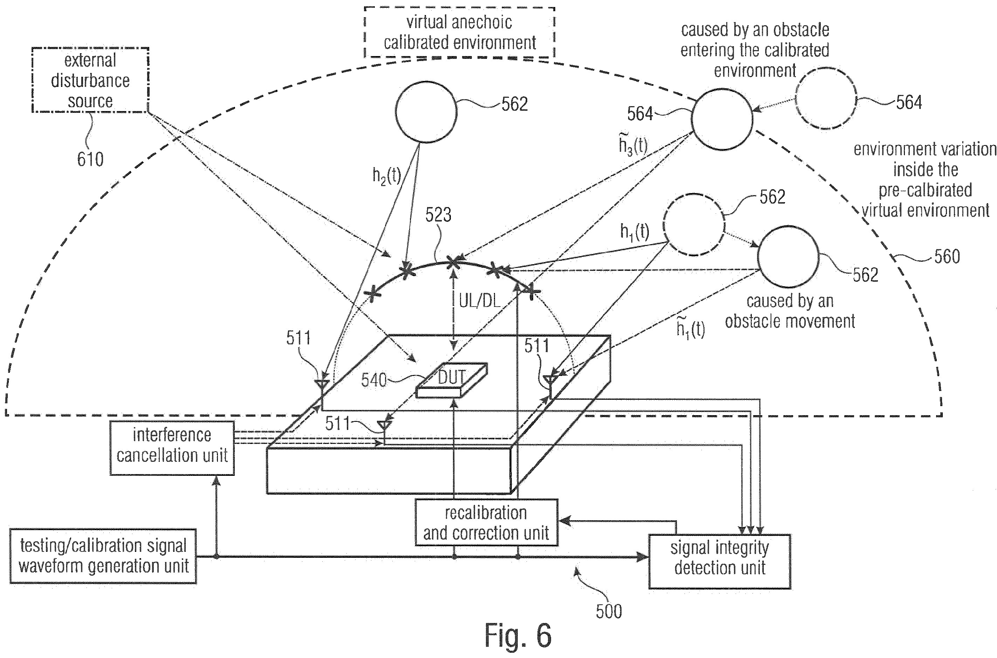

Fig. 6 shows a schematic of a measurement scenario, based on the scenario from Fig.5, in a second time step according to embodiments of the invention. In Fig. 6 one of the first obstacles 562 has moved compared to Fig. 5, causing a change of room geometry of the measurement environment. Moreover, one of the second obstacles 564 has moved closer to the system 500 and the DUT, such that its reflections are no longer negligible, leading to an additional perceived change of the room geometry. The change of room geometry is captured via the auxiliary array 511 (since the change of the room geometry is reflected by a change of signals provided by the antennas of the auxiliary array) and detected, e.g. using power detection and/or a correlation (performed on the basis of the antenna signals of the antennas of the auxiliary array 511, or on the basis of signals originating from the antennas of the auxiliary array 511 in which an impact of the transmitted signals used for the characterization of the DUT 540 is (at least partially) cancelled under the assumption of a channel corresponding to a previous room geometry). Further, the change of room geometry can be accounted for by recalibration, e.g. recalibration using unit 321, 421 and/or 313, or by labeling of the measurement as compromised.

Moreover, an additional external disturbance source 610 may be active which may be detected using the auxiliary array 511, e.g. using power detection and/or a correlation. The interference captured using the auxiliary array 511 can be used to obtain an interference estimate, which may be used to compensate for the interference in the characterization. Alternatively, the measurement may be marked as compromised and may for example be repeated.

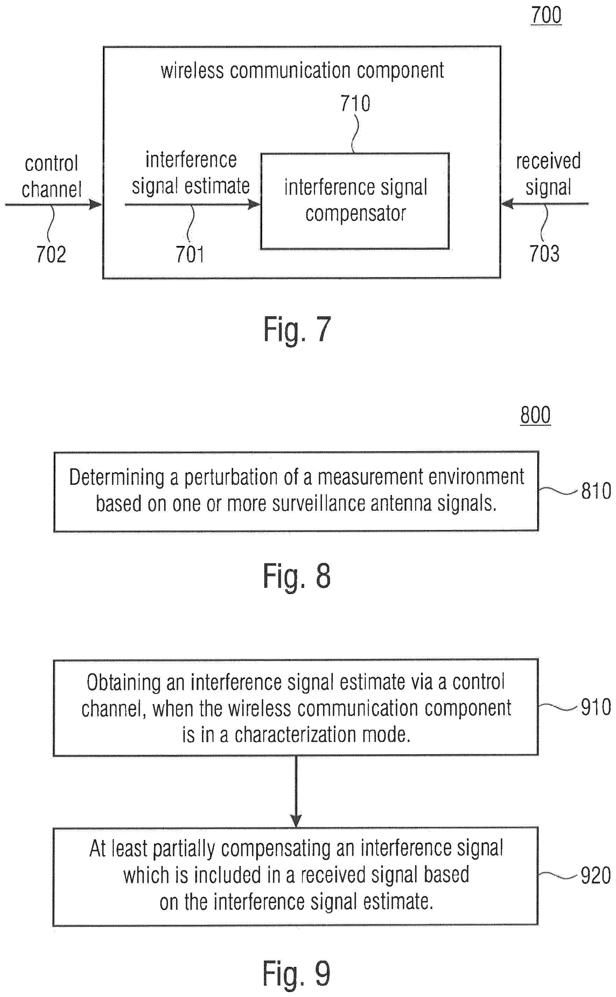

Fig. 7 shows a schematic block diagram of a wireless communication component 700 according to embodiments of the invention. The wireless communication component 700 is configured to obtain an interference signal estimate 701 via a control channel 702, when the wireless communication component 700 is in a characterization mode. Moreover, the wireless communication component may be configured to at least partially compensate an interference signal which is included in a received signal 703 based on the interference signal estimate 701. The wireless communication component 700 may for example be one of the DUTs 230, 340 or 540. The wireless communication component 700 allows fast and easy characterization using the control channel 702.

Fig. 8 shows a flow chart of a method 800 according to embodiments of the invention. The Method 800 can be used for use in a characterization of a wireless communication component/system/network in a measurement environment. The method 800 comprises determining 810 a perturbation of a measurement environment based on one or more observation antenna signals.

Fig. 9 shows a flow chart of a method 900 according to embodiments of the invention. The Method 900 can be used for characterizing a wireless communication component. The method 900 comprises obtaining 910 an interference signal estimate via a control channel, when the wireless communication component is in a characterization mode. Moreover, the method 900 comprises at least partially compensating 920 an interference signal which is included in a received signal based on the interference signal estimate

The methods 800 and 900 can be supplemented by any of the features and functionalities described herein, also with respect to the apparatus.

### Further aspects and conclusion

In the following, some aspects and thoughts according to the present invention are treated.

Anechoic chambers have been used for decades to perform RF measurements. It has been found that considering a non-anechoic environment to perform OTA measurements imposes two major issues that should be addressed:
1. **No Shielding**
   - The device is vulnerable to interference originating from external sources
   - The measurement should take place in a controlled environment, however, the device should still be able to observe unpredicted channel changes
**2. No Absorption**
   • Measurement signals travels through a multipath wireless channel
   • A pre-calibration phase should be performed in order to determine the correction needed for a particular multipath channel and the same shall be updated with respect to the changes of the wireless channel

The OTA test measurements can be performed in a non-anechoic environment providing that a prior calibration phase has been completed. The pre-calibration phase is then followed by an active OTA measurement phase throughout which the calibration should remain fully valid and, moreover, no other sporadic disturbances should occur within the active measurement phase.

According to embodiments of the present invention, the possibility of conducting such tests in an echoic and (potentially) non-stationary (The stationarity property of the channel can be violated to some certain degree with respect to the channel change from the pre-calibration phase to the active measurement phase) environment is enabled by checking the pre-calibration validity and/or observing the source of disturbances while the measurement is taking place. When the observation is being handled (as in this invention), the correction of any variation or deviation of the observed channel may optionally be performed. Additionally, the disturbances (in-band interference) caused by external sources, which could unpredictably occur any time, may optionally be dealt with.

In contrast to conventional concepts, embodiments of the present invention assures high-fidelity OTA measurements in (non-stationary) multipath environments.

In the following OTA measurements in non-anechoic environments are discussed.

The invented system offers unprecedented possibility to perform OTA measurements in non-anechoic and many other uncontrolled environments. The system mechanism is invented to observe significant changes/disturbances - that fall within the frequency range of interest - and that when they occur, the system is notified and then reacts accordingly. The invented system - including the proposed auxiliary hardware and operation procedures - offers one or more of the following features:
1. In-band disturbance detection method caused by the external sources
2. Detection of multipath channel calibration obsolescence (not being up-to-date), due to surrounding environment changes
3. Dynamic (on-the-fly) recalibration procedure for the channel information
4. Feed-forward and post-correction/evaluation capability

The need of performing the measurements in an anechoic chamber [1] can be eliminated by the utilization of the invention concept. Additionally, the same concept can be combined to enhance some existing systems such as in an anechoic chamber. For instance, integrating the invented system to a conventional anechoic chamber can offer a "watch dog" feature. In other words, the occurrence of unwanted variation can be observed and reported (if not corrected). This assures a measurement of high fidelity and no violation during such that passes through undetected (unprocessed).

Figure 5 Illustrates the non-anechoic OTA measurement system 500 concept. The auxiliary array manifold 511 and zone 560b of potential significant reflection are shown. The zone 560b of potential significant reflection is presumed to remain stationary within the pre-calibration phase. A quiet zone surrounds the DUT and measurement device setup can be imagined assuring that there are no reflections exceeding an upper bound of the reflected signal power, which can still be treated (compensated) by the system. Residing inside the quiet zone 560a should not lay an external obstacle that reflects back significant power (that could desensitize the system receivers).

Figure 5 and Figure 6 illustrate the concept of an/the improved OTA measurement system. The measuring probes and the DUT as part of any ordinary OTA measurement setup are shown in the figures. An example of the auxiliary antenna array manifold, is represented by a 3-antenna collocated (distributed) array 511 in the same figures (It should be noted that the number of the antennas is not limited to three and that their location can be anywhere within or outside of the OTA measurement environment.). The auxiliary antenna array 511 (In the realization of the system, the antenna array elements are connected to receiving front-ends. Then, the digital output from the front-ends is connected to the Interference cancellation unit.) is proposed to observe and detect the (1) unpredicted variation in the multipath environment and/or (2) the source of disturbances. This auxiliary system (e.g. apparatuses 100, 210 or 310) - an augmentation to the ordinary OTA setup - detects channel variation and/or in-band disturbances while the system performs OTA measurements (e.g. simultaneously). In other words, the OTA measurement setup calibrates a current multipath environment, then starts to perform the OTA measurements. Within the OTA measurement phase, all changes and/or disturbances to the channel that fall in the measurement frequency range of interest are detected and recorded by the auxiliary antenna array and its associated equipment. The auxiliary system is continuously fed by the OTA transmit signals, this allows the auxiliary system to distinguish between the actual (physical) multipath changes and different kind of emulated multipath; assuming that the OTA system tries to simulate (or emulate) a multipath channel, e.g. pre-equalizing (or pre-distorting) the signal for test purposes (which may be conducted by the recalibration and correction unit 321). In this, way the auxiliary system does not confuse between the deliberate/emulated multipath components and the environment caused ones, enabling by that the auxiliary system to correct for the relevant multipath changes.

Figure 6 Illustrates the non-anechoic OTA measurement system 500 concept. The influences caused by: (1) in-band disturbance external sources 610, and/or (2) due to environment changes are shown (obstacles 562 and 564 are moved). The gray shaded area 560 represents the virtual anechoic calibrated environment 560. The dotted line arrows depict the movement of the reflection obstacles that have influence on the virtual anechoic calibrated environment 560 (This is to illustrate the effectivity of the invented system in maintaining the virtual anechoic environment).

The system mechanism is engineered to cope with multipath components for the OTA measurements or any kind of measurement that requires a virtual anechoic environment. For this purpose, the system may execute a calibration phase to acquire the multipath channel reverberation and pre-/post-equalize for it, see Figure 5. During this phase, the channel is assumed to be stationary or its stationary property is handled within the estimation techniques. This calibration (estimation and equalization) routine is executed among all components - the ordinary set of OTA-device probes, DUT antennas and the auxiliary set of antennas. This calibration routine allows the on-hand setup to maintain what shall be called a virtual anechoic calibrated environment (see the gray shaded area 560 in Figure 6); it can be imagined as a space surrounding the system in which all the reflection caused by the obstacles inside it are effectively suppressed (pre-/post-equalized), and the expansion of such is dictated by the required power dynamics at the receivers of the OTA equipment. Once the knowledge of all these channels has been acquired, the system starts performing the OTA measurement.

The rest of the paragraph explains the proposed mechanism, in order to maintain a calibrated system state, an idea underlying embodiments of the invention. The auxiliary antenna array manifold 511 cancels the ongoing OTA measurement signal at their connected receivers 312, this is possible by taking advantage of the measurement waveform knowledge and the recently acquired channel knowledge during the calibration phase (self-interference cancellation techniques can be used to realize this function [2] [3] [4] [5] [6]). This enables the receivers 312 that are connected to the auxiliary antenna array manifold 511 or 311 to pick up any changes in the environment. Technically, having the interference cancelled on the auxiliary manifold 511 or 311 receivers frees their dynamic ranges and allows them to sense significant changes in the environment based on power increment detection techniques. The system detects any increment in the received signal power, records it and analyzes it in a real-time process, and then reacts accordingly. The channel variation (which may, for example, be estimated or determined based on the signals receive by the receivers) is then used to update the channel information (for example, describing the channel between a transmit antenna and the auxiliary array, and a channel between the transmit antenna and the DUT) that may have been acquired during the pre-calibration phase. These frequent channel updates based on the observed events allow the validity (calibration) of the virtual anechoic environment to be maintained.

In the following components are discussed of a system according to embodiments of the invention which may be incorporated individually or in combination into the apparatus 100 or the system 200, 300, 400 or 500. However, it should be noted that the separation into different blocks or unit may be chosen differently. In other words, some or all functionalities may be combined in a processing block, or distributed to separate apparatuses.

In the following the signal integrity detection unit 314 is further described.

During the OTA active measurement phase, this unit constantly listens to reception signal at the auxiliary array manifold 311 or 511. This allows the unit to observe the channel (surrounding) changes or 3rd source disturbances. For the sake of observance realization, power detection mechanism is utilized within this unit. The detection of power increment is reported by this unit to the Recalibration and correction unit 321 or 421. These raised flags based on the detection of power increment can be delivered to some other unit - for instance a performance evaluation unit 330, see Figure 3 or 4 - to obtain the knowledge about any disturbance that has disrupted the measurement fidelity. A deliberately created interference or perhaps interference should not be eliminated to mimic realistic cases can be fed to this unit. Hence, this unit 314 offers a feature where these declared (fed) interferences are skipped over untreated to recreate the wanted realistic environment conditions.

In the following the recalibration and correction unit 321 or 421 is further described.

For example, triggered by the Signal integrity unit 314, this unit 321 or 421 may execute a recalibration routine. Additionally, the initial phase of calibration (the precedent phase to the OTA measurement active phase) is done by this unit 321 or 421. The (re)calibration may be achieved by estimation procedure utilizing either predefined pilot sequence or a (causal) knowledge of the ongoing OTA transmission signal.

This unit may have another function, which is pre-/post-equalization; or even both equalization phases based on the implementation requirements. The equalization may be done by utilizing mainly the acquired knowledge from the (re)calibration.

In the following the interference cancellation unit 313 is further described.

This unit 313 is fed by a stream of the ongoing OTA transmission signal (most likely digital samples), e.g. the test signals, in addition to an up-to-date channel knowledge, e.g. channel estimate. The unit utilizes these feeds to cancel the self-interference cancellation (SIC) signal at the auxiliary antenna array manifold [3].

In the following an observation and correction procedure is described according to embodiments of the invention, which may be performed e.g. by system 200, 300, 400 or 500.
1. During a calibration phase the auxiliary antenna array manifold 311 or 511 simultaneously receives and estimates the characteristics of the multipath channel within the required range of frequencies
2. Once the knowledge of the required channels among the components has been obtained, the OTA measurement phase may be triggered
3. During the OTA measurement phase, the Interference cancellation unit 313 continuously cancels the received signal at its input; SIC technique is used to achieve this step [2]. This signal may go through a corresponding multipath wireless channel, by means of this channel knowledge and the ongoing OTA transmission signal feed, this signal may be canceled. By that, the power dynamic at the auxiliary receivers is freed for better sensitization. This allows the Signal integrity detection unit 314 to sense/detect based on power increasing occurrence.
4. The Signal integrity detection unit 314 may observe/detect the environmental changes by implementing a power detection mechanism. Note that; this may be enabled by means of the SIC within the former step.
5. Once a disturbance to the measurement environment has been observed, the cross-correlation property of the concurrent recorded signal may be examined to determine its category:
   *a) Uncorrelated* may indicate the presence of external source of disturbance
   *b) Correlated* may indicate a channel variation occurrence based on surrounding environment change(s)
6. Based on the previous categorization, the system (e.g. 200, 300, 400 or 500) reacts accordingly:
   a) The external source signals may be recorded and fed forward for post-correction purpose either to the DUT or the OTA device based on the link direction, see Figure 3 and Figure 4
   b) Channel-variation based changes may be used to update/re-estimate the multi-path calibration information, e.g., the reflectors geo-location may be calculated and corrected for the DUT or OTA device antenna(s)/probe(s) location

In the following some application areas are listed.

An OTA Measurement Setup in a Non-Anechoic Environment: The Down and Up Links.

Figure 3 and Figure 4 show the embodiments according to the invention in two setups of the OTA measurement, the downlink (DL) and the uplink (UL), respectively. In these two realization concepts:
- Both categories may have an *interference cancellation unit* 313 that cancels the test sequence at the auxiliary system receivers; based on the estimated channel knowledge and the test signal waveform feed [3,4].
- The *Recalibration and correction unit* 321 lies in between the *Test*/*calibration signal waveform generation unit* 322/422 and the OTA measurement device probes 323/423 for both realization cases - the DL and UL. This is due to the consideration of a pre-equalizer in the DL case and a post-equalizer for the UL case.
- The *Signal integrity detection unit* 314 has the assignment of detecting the channel variation or the in-band source of disturbances.
- Once *Signal integrity detection unit* 314 detects, the unit acts according to the disturbance type. Three feed lines connect the unit to rest of the system blocks.
- In both UL and DL implementations, the *Signal integrity detection unit* 314 may notify the *Performance evaluation unit* 330 about the detected test quality (a graded warning system can be considered for such).
- The detected channel variation by *Signal integrity detection unit* 314 may utilized to update the channel knowledge at the *Recalibration and correction unit* 321/421, this is in both UL and DL implementations as on-the-fly recalibration method.
- The *feedforward line for post correction* 341, however, differs in the DL implementation from the UL one. In the DL, it should be delivered to the DUT which is designed to offer a compatible input port and a system feature. In the UL, it can be corrected at the probes output lines, see the difference between Figure 3 and Figure 4.

Figure 3 shows a block diagram showing a system model of the functionality of the invention in the case of an OTA DL measurement. Figure 4 shows a block diagram showing a system model of the functionality of the invention in the case of an OTA UL measurement.

A third realization embodiment, the UL the and DL setups - that are illustrated in Figure 4 and Figure 3 - are combined into one setup where bidirectional link to the DUT may be required to be measured (evaluated). The combined setup is supposed to be an almost straightforward approach where both setup components are combined into one setup. The doubled units such as the Interference cancellation unit 313, and the Signal integrity detection unit 314 do not have to be repeated two times, it can be evolved to a single unit of extended functionality; to handle the jobs from both links/setups in parallel. By that, one auxiliary receiver(s) array manifold is required for this combined setup.

Embodiments describe an observation and correction method for measurement fidelity and signal integrity in non-anechoic OTA measurement environments.

An embodiment according to the invention describes a measurement device, which is capable of coping with wireless channel variations (detecting or/and correcting). In general, embodiments describe devices capable of performing OTA measurement routines in echoic environment - more generally uncontrolled environment.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, one or more of the most important method steps may be executed by such an apparatus.

Depending on certain implementation requirements, embodiments of the invention can be implemented in hardware or in software. The implementation can be performed using a digital storage medium, for example a floppy disk, a DVD, a Blu-Ray, a CD, a ROM, a PROM, an EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein. The data carrier, the digital storage medium or the recorded medium are typically tangible and/or non-transitionary.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The apparatus described herein may be implemented using a hardware apparatus, or using a computer, or using a combination of a hardware apparatus and a computer.

The apparatus described herein, or any components of the apparatus described herein, may be implemented at least partially in hardware and/or in software.

The methods described herein may be performed using a hardware apparatus, or using a computer, or using a combination of a hardware apparatus and a computer.

The methods described herein, or any components of the apparatus described herein, may be performed at least partially by hardware and/or by software.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

### Abbreviations:

- OTA: Over-the-air
- UL: Uplink
- DL: Downlink
- DUT: Device under test
- RC: Reverberation chamber
- MPAC: Multi-probe anechoic chamber
- CATR: Compact antenna test range
- SIC: Self-interference cancellation

### References:

[1] 3rd Generation Partnership Project (3GPP), "TR 37.976, Measurement of radiated performance for Multiple Input Multiple Output (MIMO) and multi-antenna reception for High Speed Packet Access (HSPA) and LTE terminals (Release 13)," 3GPP, 2016.
[2] R. Askar, B. Schubert und W. Keusgen, "TRANSCEIVER AND METHOD FOR REDUCING A SELF-INTERFERENCE OF A TRANSCEIVER". PCT Patent WO/2017/008851, 19 1 2017.
[3] R. Askar, T. Kaiser, B. Schubert, T. Haustein und W. Keusgen, "Active self-interference cancellation mechanism for full-duplex wireless transceivers," in Cognitive Radio Oriented Wireless Networks and Communications (CROWNCOM), 2014 9th International Conference on, 2014.
[4] R. Askar, B. Schubert, W. Keusgen und T. Haustein, "Agile Full-Duplex Transceiver: The Concept and Self-Interference Channel Characteristics," in European Wireless 2016; 22th European Wireless Conference, 2016*.*
[5] R. Askar, B. Schubert, W. Keusgen und T. Haustein, "Full-Duplex Wireless Transceiver in Presence of I/Q Mismatches: Experimentation and Estimation Algorithm," in IEEE GC 2015 Workshop on Emerging Technologies for 5G Wireless Cellular Networks - 4th International (GC'15 - Workshop - ET5G), 2015.
[6] R. Askar, N. Zarifeh, B. Schubert, W. Keusgen und T. Kaiser, "I/Q imbalance calibration for higher self-interference cancellation levels in Full-Duplex wireless transceivers," in 5G for Ubiquitous Connectivity (5GU), 2014 1st International Conference on, 2014.
[7] EP17173796
[8] P. S. H. Leather and J. D. Parsons, "Antenna measurement systems". US Patent 2006/0055592 A1, 16th March 2006
[9] P.S.H. Leather, J.D. Parsons, 'Equalization for antenna pattern measurements: established technique - new application', IEEE Antennas Propag. Mag., 2003, 45, (2), pp. 154-161

## Claims

1. A system (200; 300; 400; 500) for characterizing a wireless communication component (230; 340; 540; 700) in a measurement environment (560) using over-the-air test measurements, the system comprising:
a perturbation determination apparatus (100; 210; 310), wherein the perturbation determination apparatus (100; 210; 310) comprises one or more observation antennas (311; 511), wherein the perturbation determination apparatus (100; 210; 310) is configured to determine a perturbation of the measurement environment (560) based on one or more observation antenna signals (101) from the one or more observation antennas (311; 511) while one of the over-the-air test measurements is taking place; and
a characterization apparatus (220; 320, 330; 420, 330) for characterizing the wireless communication component (230; 340; 540; 700), wherein the characterization apparatus (220; 320, 330; 420, 330) comprises one or more measurement antennas (323; 523);
wherein the characterization apparatus (220; 320, 330; 420, 330) is configured to perform the over-the-air test measurements for a characterization of the wireless communication component (230; 340) using the one or more measurement antennas (323; 523);
wherein the perturbation determination apparatus (100; 210; 310) is configured to provide measurement observation information (342; 442) to a recalibration and correction unit (321; 421) of the characterization apparatus (220; 320; 420), wherein the recalibration and correction unit (321; 421) is configured for executing a recalibration routine for the characterization apparatus (220; 320; 420) based on the measurement observation information (342; 442); wherein test signals are used by the characterization apparatus (220; 320, 330; 420, 330) for the characterization of the wireless communication component (230; 340; 540; 700, wherein the perturbation determination apparatus (100; 210; 310) is configured to determine the perturbation using the test signals.

2. A system (200; 300; 400; 500) according to claim 1, wherein the perturbation determination apparatus (100; 210; 310) is configured to determine perturbations which are based on geometric changes of the measurement environment; and/or
wherein the perturbation determination apparatus (100; 210; 310) is configured to detect the perturbation, wherein determining the perturbation comprises determining a change of a propagation characteristic.

3. A system (200; 300; 400; 500) according to claim 2, wherein the perturbation determination apparatus (100; 210; 310) is configured to determine if a change of one or more of the observation antenna signals goes beyond a change of the one or more observation signals caused by an emulation of a multipath propagation, and wherein the perturbation determination apparatus (100; 210; 310) is configured to detect a perturbation in dependence on the determination.

4. A system (200; 300; 400; 500) according to one of the claims 1 to 3, wherein the perturbation determination apparatus (100; 210; 310) is configured to determine perturbations based on an interfering source (610) signal, which is included in the one or more observation antenna signals.

5. A system (200; 300; 400; 500) according to one of the claims 1 to 4, wherein the perturbation determination apparatus (100; 210; 310) is configured to at least partially compensate contributions of the test signals, used for characterization of the wireless communication component (230; 340; 540; 700), which are included in the one or more observation antenna signals.

6. A system (200; 300; 400; 500) according to one of claims 1 to 5, wherein the perturbation determination apparatus (100; 210; 310) is configured to filter the test signals using channel estimates of one or more channels among one or more antennas (311; 511) receiving the one or more observation antenna signals and one or more antennas (323; 523; 230; 340) from which the test signals are transmitted, and to at least partially cancel the filtered test signal from the one or more observation antenna signals.

7. A system (200; 300; 400; 500) according to claim 6, wherein the perturbation determination apparatus (100; 210; 310) is configured to update the channel estimates, in response to a determination of a perturbation which is based on a change of a geometry of the measurement environment.

8. A system (200; 300; 400; 500) according to one of the claims 2 to 7, wherein the perturbation determination apparatus (100; 210; 310) is configured to determine whether a perturbation is due to a change of a geometry of the measurement environment or an interfering source based on a correlation.

9. A system (200; 300; 400; 500) according to claim 8, wherein the perturbation determination apparatus (100; 210; 310) is configured to recognize a change of a geometry of the measurement environment when the perturbation determination apparatus (100; 210; 310) finds a comparatively higher correlation between the one or more observation antenna signals, or a processed version thereof, and test signals, and/or
wherein the perturbation determination apparatus (100; 210; 310) is configured to recognize an interfering source (610) causing the perturbation when the perturbation determination apparatus (100; 210; 310) finds a comparatively lower correlation between the one or more observation antenna signals, or a processed version thereof, and the test signals.

10. A system (200; 300; 400; 500) according to one of the claims 1 to 9, wherein the perturbation determination apparatus (100; 210; 310) is configured to determine a perturbation due to a change of a geometry of the measurement environment, and
wherein the perturbation determination apparatus (100; 210; 310) is configured to trigger an estimation of an up-to-date channel information, which is used in the characterization of the wireless communication component (230; 340; 540; 700), based on the determination.

11. A system (200; 300; 400; 500) according to one of the claims 1 to 10, wherein the perturbation determination apparatus (100; 210; 310) is configured to determine a perturbation based on a power detection of a received signal of the perturbation determination apparatus (100; 210; 310), such that a perturbation is indicated when a power of the received signal exceeds a predefined threshold; and/or.
wherein the perturbation determination apparatus (100; 210; 310) is configured to determine a perturbation based on a power detection of a received signal of observation antennas or based on a determination by an observation antenna receiver.

12. A system according to one of the claims 1 to 11, wherein the characterization apparatus (220; 320, 330; 420, 330) is configured to filter a transmit signal using a pre-equalization filter, such that an effect of multipath propagation at the wireless communication component is at least partially compensated, and/or such that a multipath propagation is emulated, and
wherein the perturbation determination apparatus (100; 210; 310) is configured to provide information to update the pre-equalization filter in response to a determination of a perturbation; and/or.
wherein the characterization apparatus (220; 320, 330; 420, 330) is configured to filter a receive signal with an equalization filter, such that an effect of multipath propagation between the wireless communication component and measurement antennas of the system is at least partially compensated, and/or such that a multipath propagation is emulated, and
wherein the perturbation determination apparatus (100; 210; 310) is configured to provide information to update the equalization filter in response to a determination of a perturbation.

13. A system according to one of the claims 11 to 12, wherein the system is configured to recalibrate a channel information utilizing knowledge about signals which are simultaneously used for a characterization of the wireless communication component (230; 340; 540; 700), in response to a determination of a perturbation by the perturbation determination apparatus (100; 210; 310).

14. A system according to one of the claims 11 to 13, wherein the system is configured to provide a measurement of the wireless communication component (230; 340;540; 700) based on a correction of received test signals, after a transmission of the test signals; and/or
wherein the system is configured to determine a change of a location of an object (562; 564) in the measurement environment based on a detected perturbation; and/or
wherein the system is configured to recalibrate a channel information utilizing knowledge about signals which are simultaneously used for a characterization of the wireless communication component (230; 340; 540; 700), upon determination of a change of a geometry of the measurement environment.

15. A system according to one of the claims 11 to 14, wherein the perturbation determination apparatus (100; 210; 310) is configured to at least partially compensate (313) a contribution of a test signal in an observation antenna signal, wherein the test signal is emitted by the characterization apparatus (220; 320, 330; 420, 330) or by the wireless communication component (230; 340; 540; 700).

16. Method (800) for operating a system (200; 300; 400; 500) for characterizing a wireless communication component (230; 340; 540; 700) in a measurement environment (560) using over-the-air measurements, the method comprising:
using a perturbation determination apparatus (100; 210; 310), which comprises one or more observation antennas (311; 511), for determining a perturbation of the measurement environment (560) based on one or more observation antenna signals (101) from the one or more observation antennas (311; 511) while one of the over-the-air measurements is taking place; and
using a characterization apparatus (220; 320, 330; 420, 330) for characterizing the wireless communication component (230; 340; 540; 700), wherein the characterization apparatus (220; 320, 330; 420, 330) comprises one or more measurement antennas (323; 523), wherein the characterization apparatus (220; 320, 330; 420, 330) is used to perform the over-the-air measurements for a characterization of the wireless communication component (230; 340) using the one or more measurement antennas (323; 523);
using the perturbation determination apparatus (100; 210; 310) for providing measurement observation information (342; 442) to a recalibration and correction unit (321; 421) of the characterization apparatus (220; 320; 420), wherein the recalibration and correction unit (321; 421) is used for executing a recalibration routine for the characterization apparatus (220; 320; 420) based on the measurement observation information (342; 442);
using test signals by the characterization apparatus (220; 320, 330; 420, 330) for the characterization of the wireless communication component (230; 340; 540; 700, wherein the perturbation determination apparatus (100; 210; 310) is used to determine the perturbation using the test signals.

17. Computer program with a program code for performing the method according to claim 16, when the computer program runs on a computer or a microcontroller.

## Patentansprüche

1. Ein System (200; 300; 400; 500) zum Charakterisieren einer Drahtloskommunikationskomponente (230; 340; 540; 700) in einer Messumgebung (560) unter Verwendung von Over-the-Air-Testmessungen, wobei das System folgende Merkmale aufweist:
eine Störungsbestimmungsvorrichtung (100; 210; 310), wobei die Störungsbestimmungsvorrichtung (100; 210; 310) eine oder mehrere Beobachtungsantennen (311; 511) aufweist, wobei die Störungsbestimmungsvorrichtung (100; 210; 310) dazu konfiguriert ist, eine Störung der Messumgebung (560) basierend auf einem oder mehreren Beobachtungsantennensignalen (101) von der einen oder den mehreren Beobachtungsantennen (311; 511) zu bestimmen, während eine der Over-the-Air-Testmessungen stattfindet; und
eine Charakterisierungsvorrichtung (220; 320, 330; 420, 330) zum Charakterisieren der Drahtloskommunikationskomponente (230; 340; 540; 700), wobei die Charakterisierungsvorrichtung (220; 320, 330; 420, 330) eine oder mehrere Messantennen (323; 523) aufweist;
wobei die Charakterisierungsvorrichtung (220; 320, 330; 420, 330) dazu konfiguriert ist, die Over-the-Air-Testmessungen für eine Charakterisierung der Drahtloskommunikationskomponente (230; 340) unter Verwendung der einen oder der mehreren Messantennen (323; 523) durchzuführen;
wobei die Störungsbestimmungsvorrichtung (100; 210; 310) dazu konfiguriert ist, Messbeobachtungsinformationen (342; 442) einer Neukalibrierungs- und Korrektureinheit (321; 421) der Charakterisierungsvorrichtung (220; 320; 420) bereitzustellen, wobei die Neukalibrierungs- und Korrektureinheit (321; 421) dazu konfiguriert ist, eine Neukalibrierungsroutine für die Charakterisierungsvorrichtung (220; 320; 420) basierend auf den Messbeobachtungsinformationen (342; 442) auszuführen; wobei Testsignale durch die Charakterisierungsvorrichtung (220; 320, 330; 420, 330) für die Charakterisierung der Drahtloskommunikationskomponente (230; 340; 540; 700) verwendet werden, wobei die Störungsbestimmungsvorrichtung (100; 210; 310) dazu konfiguriert ist, die Störung unter Verwendung der Testsignale zu bestimmen.

2. Ein System (200; 300; 400; 500) gemäß Anspruch 1, wobei die Störungsbestimmungsvorrichtung (100; 210; 310) dazu konfiguriert ist, Störungen zu bestimmen, die auf geometrischen Änderungen der Messumgebung basieren; und/oder
wobei die Störungsbestimmungsvorrichtung (100; 210; 310) dazu konfiguriert ist, die Störung zu erfassen, wobei das Bestimmen der Störung ein Bestimmen einer Änderung einer Ausbreitungscharakteristik aufweist.

3. Ein System (200; 300; 400; 500) gemäß Anspruch 2, wobei die Störungsbestimmungsvorrichtung (100; 210; 310) dazu konfiguriert ist, zu bestimmen, ob eine Änderung von einem oder mehreren der Beobachtungsantennensignale über eine Änderung des einen oder der mehreren Beobachtungssignale hinausgeht, die durch eine Emulation einer Mehrwegeausbreitung verursacht wird, und wobei die Störungsbestimmungsvorrichtung (100; 210; 310) dazu konfiguriert ist, eine Störung in Abhängigkeit von der Bestimmung zu erfassen.

4. Ein System (200; 300; 400; 500) gemäß einem der Ansprüche 1 bis 3, wobei die Störungsbestimmungsvorrichtung (100; 210; 310) dazu konfiguriert ist, Störungen basierend auf einem Signal einer Störquelle (610) zu bestimmen, das in dem einen oder den mehreren Beobachtungsantennensignalen enthalten ist.

5. Ein System (200; 300; 400; 500) gemäß einem der Ansprüche 1 bis 4, wobei die Störungsbestimmungsvorrichtung (100; 210; 310) dazu konfiguriert ist, Beiträge der Testsignale, die zur Charakterisierung der Drahtloskommunikationskomponente (230; 340; 540; 700) verwendet werden, die in dem einen oder den mehreren Beobachtungsantennensignalen enthalten sind, zumindest teilweise zu kompensieren.

6. Ein System (200; 300; 400; 500) gemäß einem der Ansprüche 1 bis 5, wobei die Störungsbestimmungsvorrichtung (100; 210; 310) dazu konfiguriert ist, die Testsignale unter Verwendung von Kanalschätzungen von einem oder mehreren Kanälen unter einer oder mehreren Antennen (311; 511), die das eine oder die mehreren Beobachtungsantennensignale empfangen, und einer oder mehreren Antennen (323; 523; 230; 340), von denen die Testsignale übertragen werden, zu filtern und das gefilterte Testsignal zumindest teilweise aus dem einen oder den mehreren Beobachtungsantennensignalen zu beseitigen.

7. Ein System (200; 300; 400; 500) gemäß Anspruch 6, wobei die Störungsbestimmungsvorrichtung (100; 210; 310) dazu konfiguriert ist, die Kanalschätzungen ansprechend auf eine Bestimmung einer Störung, die auf einer Änderung einer Geometrie der Messumgebung basiert, zu aktualisieren.

8. Ein System (200; 300; 400; 500) gemäß einem der Ansprüche 2 bis 7, wobei die Störungsbestimmungsvorrichtung (100; 210; 310) dazu konfiguriert ist, basierend auf einer Korrelation zu bestimmen, ob eine Störung auf eine Änderung einer Geometrie der Messumgebung oder einer Störquelle zurückzuführen ist.

9. Ein System (200; 300; 400; 500) gemäß Anspruch 8, wobei die Störungsbestimmungsvorrichtung (100; 210; 310) dazu konfiguriert ist, eine Änderung einer Geometrie der Messumgebung zu erkennen, wenn die Störungsbestimmungsvorrichtung (100; 210; 310) eine vergleichsweise höhere Korrelation zwischen dem einen oder den mehreren Beobachtungsantennensignalen oder einer verarbeiteten Version davon und Testsignalen findet, und/oder
wobei die Störungsbestimmungsvorrichtung (100; 210; 310) dazu konfiguriert ist, eine Störquelle (610), die die Störung verursacht, zu erkennen, wenn die Störungsbestimmungsvorrichtung (100; 210; 310) eine vergleichsweise niedrigere Korrelation zwischen dem einen oder den mehreren Beobachtungsantennensignalen oder einer verarbeiteten Version davon und den Testsignalen findet.

10. Ein System (200; 300; 400; 500) gemäß einem der Ansprüche 1 bis 9, wobei die Störungsbestimmungsvorrichtung (100; 210; 310) dazu konfiguriert ist, eine Störung aufgrund einer Änderung einer Geometrie der Messumgebung zu bestimmen, und
wobei die Störungsbestimmungsvorrichtung (100; 210; 310) dazu konfiguriert ist, basierend auf der Bestimmung eine Schätzung einer aktuellen Kanalinformation auszulösen, die bei der Charakterisierung der Drahtloskommunikationskomponente (230; 340; 540; 700) verwendet wird.

11. Ein System (200; 300; 400; 500) gemäß einem der Ansprüche 1 bis 10, wobei die Störungsbestimmungsvorrichtung (100; 210; 310) dazu konfiguriert ist, eine Störung basierend auf einer Leistungserfassung eines empfangenen Signals der Störungsbestimmungsvorrichtung (100; 210; 310) zu bestimmen, so dass eine Störung angezeigt wird, wenn eine Leistung des empfangenen Signals einen vordefinierten Schwellenwert überschreitet; und/oder
wobei die Störungsbestimmungsvorrichtung (100; 210; 310) dazu konfiguriert ist, eine Störung basierend auf einer Leistungserfassung eines empfangenen Signals von Beobachtungsantennen oder basierend auf einer Bestimmung durch einen Beobachtungsantennenempfänger zu bestimmen.

12. Ein System gemäß einem der Ansprüche 1 bis 11, wobei die Charakterisierungsvorrichtung (220; 320, 330; 420, 330) dazu konfiguriert ist, ein Übertragungssignal unter Verwendung eines Vorentzerrungsfilters zu filtern, so dass ein Effekt einer Mehrwegeausbreitung an der Drahtloskommunikationskomponente zumindest teilweise kompensiert wird, und/oder so dass eine Mehrwegeausbreitung emuliert wird, und
wobei die Störungsbestimmungsvorrichtung (100; 210; 310) dazu konfiguriert ist, Informationen zum Aktualisieren des Vorentzerrungsfilters ansprechend auf eine Bestimmung einer Störung bereitzustellen; und/oder
wobei die Charakterisierungsvorrichtung (220; 320, 330; 420, 330) dazu konfiguriert ist, ein Empfangssignal mit einem Entzerrungsfilter zu filtern, so dass ein Effekt einer Mehrwegeausbreitung zwischen der Drahtloskommunikationskomponente und Messantennen des Systems zumindest teilweise kompensiert wird, und/oder so dass eine Mehrwegeausbreitung emuliert wird, und
wobei die Störungsbestimmungsvorrichtung (100; 210; 310) dazu konfiguriert ist, Informationen zum Aktualisieren des Entzerrungsfilters ansprechend auf eine Bestimmung einer Störung bereitzustellen.

13. Ein System gemäß einem der Ansprüche 11 bis 12, wobei das System dazu konfiguriert ist, eine Kanalinformation unter Verwendung von Wissen über Signale, die gleichzeitig für eine Charakterisierung der Drahtloskommunikationskomponente (230; 340; 540; 700) verwendet werden, ansprechend auf eine Bestimmung einer Störung durch die Störungsbestimmungsvorrichtung (100; 210; 310) neu zu kalibrieren.

14. Ein System gemäß einem der Ansprüche 11 bis 13, wobei das System dazu konfiguriert ist, eine Messung der Drahtloskommunikationskomponente (230; 340; 540; 700) basierend auf einer Korrektur von empfangenen Testsignalen nach einer Übertragung der Testsignale bereitzustellen; und/oder
wobei das System dazu konfiguriert ist, eine Änderung einer Position eines Objekts (562; 564) in der Messumgebung basierend auf einer erfassten Störung zu bestimmen; und/oder
wobei das System dazu konfiguriert ist, eine Kanalinformation unter Verwendung von Wissen über Signale, die gleichzeitig für eine Charakterisierung Drahtloskommunikationskomponente (230; 340; 540; 700) verwendet werden, auf eine Bestimmung einer Änderung einer Geometrie der Messumgebung hin neu zu kalibrieren.

15. Ein System gemäß einem der Ansprüche 11 bis 14, wobei die Störungsbestimmungsvorrichtung (100; 210; 310) dazu konfiguriert ist, einen Beitrag eines Testsignals in einem Beobachtungsantennensignal zumindest teilweise zu kompensieren (313), wobei das Testsignal durch die Charakterisierungsvorrichtung (220; 320, 330; 420, 330) oder durch die Drahtloskommunikationskomponente (230; 340; 540; 700) emittiert wird.

16. Ein Verfahren (800) zum Betreiben eines Systems (200; 300; 400; 500) zum Charakterisieren einer Drahtloskommunikationskomponente (230; 340; 540; 700) in einer Messumgebung (560) unter Verwendung von Over-the-Air-Messungen, wobei das Verfahren folgende Schritte aufweist:
Verwenden einer Störungsbestimmungsvorrichtung (100; 210; 310), die eine oder mehrere Beobachtungsantennen (311; 511) aufweist, zum Bestimmen einer Störung der Messumgebung (560) basierend auf einem oder mehreren Beobachtungsantennensignalen (101) von der einen oder den mehreren Beobachtungsantennen (311; 511), während eine der Over-the-Air-Messungen stattfindet; und Verwenden einer Charakterisierungsvorrichtung (220; 320, 330; 420, 330) zum Charakterisieren der Drahtloskommunikationskomponente (230; 340; 540; 700), wobei die Charakterisierungsvorrichtung (220; 320, 330; 420, 330) eine oder mehrere Messantennen (323; 523) aufweist, wobei die Charakterisierungsvorrichtung (220; 320, 330; 420, 330) dazu verwendet wird, die Over-the-Air-Messungen für eine Charakterisierung der Drahtloskommunikationskomponente (230; 340) unter Verwendung der einen oder der mehreren Messantennen (323; 523) durchzuführen;
Verwenden der Störungsbestimmungsvorrichtung (100; 210; 310) zum Bereitstellen von Messbeobachtungsinformationen (342; 442) einer Neukalibrierungs- und Korrektureinheit (321; 421) der Charakterisierungsvorrichtung (220; 320; 420), wobei die Neukalibrierungs- und Korrektureinheit (321; 421) dazu verwendet wird, eine Neukalibrierungsroutine für die Charakterisierungsvorrichtung (220; 320; 420) basierend auf den Messbeobachtungsinformationen (342; 442) auszuführen;
Verwenden von Testsignalen durch die Charakterisierungsvorrichtung (220; 320, 330; 420, 330) für die Charakterisierung der Drahtloskommunikationskomponente (230; 340; 540; 700), wobei die Störungsbestimmungsvorrichtung (100; 210; 310) dazu verwendet wird, die Störung unter Verwendung der Testsignale zu bestimmen.

17. Computerprogramm mit einem Programmcode zum Durchführen des Verfahrens gemäß Anspruch 16, wenn das Computerprogramm auf einem Computer oder einem Mikrocontroller läuft.

## Revendications

1. Système (200 ; 300 ; 400 ; 500) pour la caractérisation d'un composant de communication sans fil (230 ; 340 ; 540 ; 700) dans un environnement de mesure (560) en utilisant des mesures de test par liaison radio, le système comprenant :
un appareil de détermination de perturbation (100 ; 210 ; 310), dans lequel l'appareil de détermination de perturbation (100 ; 210 ; 310) comprend une ou plusieurs antennes d'observation (311 ; 511), dans lequel l'appareil de détermination de perturbation (100 ; 210 ; 310) est configuré pour déterminer une perturbation de l'environnement de mesure (560) en fonction d'un ou de plusieurs signaux d'antenne d'observation (101) provenant de l'une ou des antennes d'observation (311 ; 511) pendant qu'une des mesures de test par liaison radio est en cours ; et
un appareil de caractérisation (220 ; 320, 330 ; 420, 330) pour la caractérisation du composant de communication sans fil (230 ; 340 ; 540 ; 700), dans lequel l'appareil de caractérisation (220 ; 320, 330 ; 420, 330) comprend une ou plusieurs antennes de mesure (323 ; 523) ;
dans lequel l'appareil de caractérisation (220 ; 320, 330 ; 420, 330) est configuré pour effectuer les mesures de test par liaison radio pour la caractérisation du composant de communication sans fil (230 ; 340) en utilisant l'une ou les antennes de mesure (323 ; 523) ;
dans lequel l'appareil de détermination de perturbation (100 ; 210 ; 310) est configuré pour fournir des informations d'observation de mesure (342 ; 442) à une unité de recalibrage et de correction (321 ; 421) de l'appareil de caractérisation (220 ; 320 ; 420), dans lequel l'unité de recalibrage et de correction (321 ; 421) est configurée pour exécuter une routine de recalibrage pour l'appareil de caractérisation (220 ; 320 ; 420) en fonction des informations d'observation de mesure (342 ; 442) ; dans lequel des signaux de test sont utilisés par l'appareil de caractérisation (220 ; 320, 330 ; 420, 330) pour la caractérisation du composant de communication sans fil (230 ; 340 ; 540 ; 700), dans lequel l'appareil de détermination de perturbation (100 ; 210 ; 310) est configuré pour déterminer la perturbation en utilisant les signaux de test.

2. Système (200 ; 300 ; 400 ; 500) selon la revendication 1, dans lequel l'appareil de détermination de perturbation (100 ; 210 ; 310) est configuré pour déterminer des perturbations en fonction de changements géométriques de l'environnement de mesure ; et/ou
dans lequel l'appareil de détermination de perturbation (100 ; 210 ; 310) est configuré pour détecter la perturbation, dans lequel la détermination de la perturbation comprend la détermination d'un changement d'une caractéristique de propagation.

3. Système (200 ; 300 ; 400 ; 500) selon la revendication 2, dans lequel l'appareil de détermination de perturbation (100 ; 210 ; 310) est configuré pour déterminer si un changement d'un ou de plusieurs des signaux d'antenne d'observation dépasse un changement de l'un ou des signaux d'observation provoqués par une émulation d'une propagation par trajets multiples, et dans lequel l'appareil de détermination de perturbation (100 ; 210 ; 310) est configuré pour détecter une perturbation dépendant de la détermination.

4. Système (200 ; 300 ; 400 ; 500) selon l'une des revendications 1 à 3, dans lequel l'appareil de détermination de perturbation (100 ; 210 ; 310) est configuré pour déterminer des perturbations en fonction d'un signal de source d'interférence (610), qui est inclus dans le ou les signaux d'antenne d'observation.

5. Système (200 ; 300 ; 400 ; 500) selon l'une des revendications 1 à 4, dans lequel l'appareil de détermination de perturbation (100 ; 210 ; 310) est configuré pour compenser au moins partiellement des contributions des signaux de test, utilisés pour la caractérisation du composant de communication sans fil (230 ; 340 ; 540 ; 700), qui sont inclus dans le ou les signaux d'antenne d'observation.

6. Système (200 ; 300 ; 400 ; 500) selon l'une des revendications 1 à 5, dans lequel l'appareil de détermination de perturbation (100 ; 210 ; 310) est configuré pour filtrer les signaux de test en utilisant des estimations de canal d'un ou de plusieurs canaux parmi une ou plusieurs antennes (311 ; 511) recevant le ou les signaux d'antenne d'observation et une ou plusieurs antennes (323 ; 523 ; 230 ; 340) depuis lesquelles les signaux de test sont transmis, et à annuler au moins partiellement le signal de test filtré provenant du ou des signaux d'antenne d'observation.

7. Système (200 ; 300 ; 400 ; 500) selon la revendication 6, dans lequel l'appareil de détermination de perturbation (100 ; 210 ; 310) est configuré pour mettre à jour les estimations de canal, en réponse à la détermination d'une perturbation en fonction d'un changement d'une géométrie de l'environnement de mesure.

8. Système (200 ; 300 ; 400 ; 500) selon l'une des revendications 2 à 7, dans lequel l'appareil de détermination de perturbation (100 ; 210 ; 310) est configuré pour déterminer si une perturbation est due à un changement d'une géométrie de l'environnement de mesure ou à une source d'interférence en fonction d'une corrélation.

9. Système (200 ; 300 ; 400 ; 500) selon la revendication 8, dans lequel l'appareil de détermination de perturbation (100 ; 210 ; 310) est configuré pour reconnaître un changement d'une géométrie de l'environnement de mesure lorsque l'appareil de détermination de perturbation (100 ; 210 ; 310) trouve une corrélation comparativement plus élevée entre le ou les signaux d'antenne d'observation, ou une version traitée de ceux-ci, et des signaux de test, et/ou
dans lequel l'appareil de détermination de perturbation (100 ; 210 ; 310) est configuré pour identifier une source d'interférence (610) causant la perturbation lorsque l'appareil de détermination de perturbation (100 ; 210 ; 310) trouve une corrélation comparativement plus faible entre le ou les signaux d'antenne d'observation, ou une version traitée de ceux-ci, et les signaux de test.

10. Système (200 ; 300 ; 400 ; 500) selon l'une des revendications 1 à 9, dans lequel l'appareil de détermination de perturbation (100 ; 210 ; 310) est configuré pour déterminer une perturbation due à un changement d'une géométrie de l'environnement de mesure, et
dans lequel l'appareil de détermination de perturbation (100 ; 210 ; 310) est configuré pour déclencher une estimation d'informations de canal mises à jour, qui est utilisée dans la caractérisation du composant de communication sans fil (230 ; 340 ; 540 ; 700), en fonction de la détermination.

11. Système (200 ; 300 ; 400 ; 500) selon l'une des revendications 1 à 10, dans lequel l'appareil de détermination de perturbation (100 ; 210 ; 310) est configuré pour déterminer une perturbation en fonction d'une détection de puissance d'un signal reçu de l'appareil de détermination de perturbation (100 ; 210 ; 310), de telle sorte qu'une perturbation soit indiquée lorsqu'une puissance du signal reçu excède un seuil prédéfini ; et/ou
dans lequel l'appareil de détermination de perturbation (100 ; 210 ; 310) est configuré pour déterminer une perturbation en fonction d'une détection de puissance d'un signal reçu des antennes d'observation ou en fonction d'une détermination par un récepteur d'antenne d'observation.

12. Système selon l'une des revendications 1 à 11, dans lequel l'appareil de caractérisation (220 ; 320, 330 ; 420, 330) est configuré pour filtrer un signal d'émission en utilisant un filtre de pré-égalisation, de telle sorte qu'un effet de propagation par trajets multiples au niveau du composant de communication sans fil soit au moins partiellement compensé, et/ou de telle sorte qu'une propagation par trajets multiples soit émulée, et
dans lequel l'appareil de détermination de perturbation (100 ; 210 ; 310) est configuré pour fournir des informations pour mettre à jour le filtre de pré-égalisation en réponse à une détermination d'une perturbation ; et/ou
dans lequel l'appareil de caractérisation (220 ; 320, 330 ; 420, 330) est configuré pour filtrer un signal reçu avec un filtre d'égalisation, de telle sorte qu'un effet de propagation par trajets multiples entre le composant de communication sans fil et les antennes de mesure du système soit au moins partiellement compensé, et/ou de telle sorte qu'une propagation par trajets multiples soit émulée, et
dans lequel l'appareil de détermination de perturbation (100 ; 210 ; 310) est configuré pour fournir des informations pour mettre à jour le filtre d'égalisation en réponse à une détermination d'une perturbation.

13. Système selon l'une des revendications 11 à 12, dans lequel le système est configuré pour recalibrer une information de canal en utilisant des connaissances relatives à des signaux qui sont simultanément utilisées pour une caractérisation du composant de communication sans fil (230 ; 340 ; 540 ; 700), en réponse à la détermination d'une perturbation par l'appareil de détermination de perturbation (100 ; 210 ; 310).

14. Système selon l'une des revendications 11 à 13, dans lequel le système est configuré pour fournir une mesure du composant de communication sans fil (230 ; 340 ; 540 ; 700) en fonction d'une correction des signaux de test reçus, après une transmission des signaux de test ; et/ou
dans lequel le système est configuré pour déterminer un changement d'une position d'un objet (562 ; 564) dans l'environnement de mesure en fonction d'une perturbation détectée ; et/ou
dans lequel le système est configuré pour recalibrer une information de canal en utilisant des connaissances relatives à des signaux qui sont simultanément utilisées pour une caractérisation du composant de communication sans fil (230 ; 340 ; 540 ; 700), dès la détermination d'un changement d'une géométrie de l'environnement de mesure.

15. Système selon l'une des revendications 11 à 14, dans lequel l'appareil de détermination de perturbation (100 ; 210 ; 310) est configuré pour compenser au moins partiellement (313) une contribution d'un signal de test dans un signal d'antenne d'observation, dans lequel le signal de test est émis par l'appareil de caractérisation (220 ; 320, 330 ; 420, 330) ou par le composant de communication sans fil (230 ; 340 ; 540 ; 700).

16. Procédé (800) de fonctionnement d'un système (200 ; 300 ; 400 ; 500) pour la caractérisation d'un composant de communication sans fil (230 ; 340 ; 540 ; 700) dans un environnement de mesure (560) en utilisant des mesures par liaison radio, le procédé comprenant :
l'utilisation d'un appareil de détermination de perturbation (100 ; 210 ; 310), qui comprend une ou plusieurs antennes d'observation (311 ; 511), pour la détermination d'une perturbation de l'environnement de mesure (560) en fonction d'un ou de plusieurs signaux d'antenne d'observation (101) depuis la ou les antennes d'observation (311 ; 511) pendant qu'une des mesures par liaison radio est en cours ; et
l'utilisation d'un appareil de caractérisation (220 ; 320, 330 ; 420, 330) pour la caractérisation du composant de communication sans fil (230 ; 340 ; 540 ; 700), dans laquelle l'appareil de caractérisation (220 ; 320, 330 ; 420, 330) comprend une ou plusieurs antennes de mesure (323 ; 523), dans laquelle l'appareil de caractérisation (220 ; 320, 330 ; 420, 330) est utilisé pour effectuer les mesures par liaison radio pour une caractérisation du composant de communication sans fil (230 ; 340) en utilisant la ou les antennes de mesure (323 ; 523) ;
l'utilisation de l'appareil de détermination de perturbation (100 ; 210 ; 310) pour la fourniture d'informations d'observation de mesure (342 ; 442) à une unité de recalibrage et de correction (321 ; 421) de l'appareil de caractérisation (220 ; 320 ; 420), dans laquelle l'unité de recalibrage et de correction (321 ; 421) est utilisée pour exécuter une routine de recalibrage pour l'appareil de caractérisation (220 ; 320 ; 420) en fonction des informations d'observation de mesure (342 ; 442) ;
l'utilisation de signaux de test par l'appareil de caractérisation (220 ; 320, 330 ; 420, 330) pour la caractérisation du composant de communication sans fil (230 ; 340 ; 540 ; 700), dans laquelle l'appareil de détermination de perturbation (100 ; 210 ; 310) est utilisé pour déterminer la perturbation en utilisant les signaux de test.

17. Programme informatique avec un code de programme pour mettre en œuvre le procédé selon la revendication 16, lorsque le programme informatique est exécuté sur un ordinateur ou un microcontrôleur.
